# EUROPEAN PATENT APPLICATION

(11) **EP 2 469 268 A1**
(43) Date of publication of application: **27.06.2012**
(21) Application number: 10196882.4
(22) Date of filing: 23.12.2010
(51) Int. Cl.: G01N 21/85, C23C 14/54

(54) **Evaporation system with measurement unit**

(71) Applicant: Applied Materials, Inc., Santa Clara, CA 95054 (US)
(72) Inventor: Dieguez-Campo, Jose Manuel, 63457 Hanau (DE); Hoffmann, Uwe, 63755 Alzenau (DE); Johannes, Hans Herrmann, 38124 Braunschweig (DE); Fabig, Stefan, 38106 Braunschweig (DE); Kowalski, Wolfgang, 38116 Braunschweig (DE)
(74) Representative: Zimmermann & Partner

(57) **Abstract**

An evaporation system for applying vapor to a substrate in a vacuum chamber at a coating rate comprises a distribution pipe with an inlet for receiving the vapor; an evaporation section having a first outlet for applying the vapor to a substrate, the evaporation section defining a first fluidal path for the vapor to go from the inlet to the first outlet; a measurement section having a second outlet for displacing the vapor from the measurement section, the measurement section defining a second fluidal path for the vapor to go from the inlet to the second outlet; and a light sensitive detector for measuring at least one characteristic property of the vapor in the measurement section. Further, a vacuum chamber including an evaporation system is disclosed, and a method for measuring the application rate of a vapor.

## Description

### TECHNICAL FIELD OF THE INVENTION

The present invention relates to an evaporation system for use in a vacuum installation, a coating installation including the evaporation system, and a method of using the same. The present invention particularly relates to an organic evaporation system with a measurement system for measuring a coating rate, a coating installation having such an evaporation system and a method for use thereof.

### BACKGROUND OF THE INVENTION

Organic evaporators are an essential tool for the production of organic light-emitting diodes (OLED). OLEDs are a special type of light-emitting diodes in which the emissive layer comprises a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED display is considerably less than that of traditional LCD displays. Further, the fact that OLEDs can be printed onto flexible substrates opens the door to new applications such as roll-up displays or even displays embedded in clothing.

The functionality of an OLED depends on the coating thickness of the organic material. This thickness has to be within a predetermined range. In the production of OLEDs it is therefore important, that the coating rate at which the coating with organic material is effected lies within a predetermined tolerance range. In other words, the coating rate of an organic evaporator has to be controlled thoroughly in the production process.

In order to do so, it is known in the art to use so called oscillating crystals for the determination of the coating rate. The measurement of the actual oscillating frequency of these oscillating crystals allows the conclusion on the actual coating rate. However, these crystals are also vaporized with organic material in the coating process. Therefore, the crystals have to be replaced periodically because they tolerate only a limited amount of material coating. This reduces their usability particularly in large scale production plants with very long services lives. Furthermore, in order to replace the oscillating crystals, interventions into the vacuum chamber are necessary. Regenerating the vacuum is time-consuming and expensive.

Alternatively, it is known in the art that the deposited layer is analyzed after the deposition is complete in order to determine the coating rate. In this case, the feedback control of the deposition system is only possible with a certain delay. In particular, this procedure can result in one or more substrates being coated with a layer that is out of range before the control can take corrective action. These substrates are rejects.

In view of the above, it is the object of the present invention to provide an evaporation system, a coating installation, and a method for measuring the evaporation rate to a substrate that overcome at least some of the problems in the art.

### SUMMARY OF THE INVENTION

The problems in the art are at least partly overcome by the evaporation system according to claim 1, and a method according to claim 10. More particularly, an organic evaporation system and a coating installation are provided, wherein the rate determination allows an instantaneous control and wherein vapour used in the rate measurement is not used for the coating of a substrate. Further aspects, details, and advantages are evident from the dependent claims, the description, and the accompanying drawings.

In view of the above, the present invention provides an evaporation system for applying vapor to a substrate in a vacuum chamber at a coating rate, the system including a distribution pipe having an inlet for receiving the vapor; an evaporation section having a first outlet for applying the vapor to a substrate, the evaporation section defining a first fluidal path for the vapor to go from the inlet to the first outlet; a measurement section having a second outlet for displacing the vapor from the measurement section, the measurement section defining a second fluidal path for the vapor to go from the inlet to the second outlet; and a light sensitive detector for measuring at least one characteristic property of the vapor in the measurement section.

According to a further aspect of the present invention, a method for measuring the application rate of vapor to a substrate in a vacuum chamber includes providing vapor in a distribution pipe; applying a first portion of the vapor to the substrate; diverting a second portion of the vapor to a measurement section; applying laser light to the vapor in the measurement section; and measuring at least one characteristic property of the vapor.

### BRIEF DESCRIPTION OF THE DRAWINGS

Embodiments of the present invention are depicted in the drawings and will be described in more detail in the following. Therein:
- Figs. 1 to 6: show various embodiments of the evaporation system as seen from a substrate to be coated.
- Figs. 7 to 8: show various embodiments of the evaporation system in a side view perspective.
- Fig.9: shows an embodiment of an evaporation system and an analyzer.
- Fig. 10: shows a vacuum chamber with an evaporation system according to embodiments.

### DETAILED DESCRIPTION OF EMBODIMENTS

Reference will now be made in detail to the various embodiments of the invention, one or more examples of which are illustrated in the figures. Each example is provided by way of explanation of the invention, and is not meant as a limitation of the invention. For example, features illustrated or described as part of one embodiment can be used on or in conjunction with other embodiments to yield yet a further embodiment. It is intended that the present invention includes such modifications and variations.

Embodiments of the present invention provide an evaporation system, henceforth also called evaporator, for applying vapor to a substrate in a vacuum chamber at a coating rate. The evaporator has a distribution pipe including an inlet for receiving the vapor and an evaporation section having a first outlet for applying the vapor to a substrate. The evaporation section defines a first fluidal path for the vapor to go from the inlet to the first outlet. The distribution pipe further has a measurement section with a second outlet for displacing the vapor from the measurement section, wherein the measurement section defines a second fluidal path for the vapor to go from the inlet to the second outlet. Further, a light sensitive detector is provided for measuring at least one characteristic property of the vapor in the measurement section.

The coating rate of the evaporator depends on the pressure of the material which has to be evaporated in the distribution pipe. This pressure corresponds to the vapor pressure of the material. Thus, there is a sufficient high pressure to enable the measurement of a significant signal of a characteristic property of the vapor. The embodiments described herein relate to the application of an organic material to a substrate. However, embodiments of the present invention may also be applied for the coating of non-organic substances, i.e., anorganic substances, provided that they have characteristic absorption bands for the measurement process.

In typical embodiments of the present invention, the measurement is performed in a noncontacting way. The elements of the measurement device, such as a light source and a detector, are typically arranged outside the distribution pipe.

In typical embodiments of the present invention, the absorption rate of the vapor is measured as the characteristic property of the vapor. For instance, organic materials possess specific absorption bands. According to the Lambert-Beer-law, the absorption depends on the concentration and thus on the pressure of the material to be evaporated within the distribution pipe. Hence, it is possible to deduce the pressure of the material in the distribution pipe from the absorption of certain wavelengths within the distribution pipe. A laser may be used as illumination source for illuminating the vapor. Typically, the intensity of the wavelength distribution of the illumination source used is high at a wavelength at or close to the absorption wavelength of the material measured. Typical organic materials are e.g. Alq3, NBP, TNATA and others.

Alternatively, or in addition to the measurement of the absorption as characteristic property of the organic vapor, it is possible to measure the photoluminescence of the organic vapor. The vapor of the organic material is excited by illuminating it with radiation. Typically, the vapor is illuminated with a certain wavelength. The excited molecules fall back to the ground state thereby emitting radiation. The characteristic emission wavelength can be detected using an emission spectrometer as detector. The intensity of the emission depends on the pressure of the material to be evaporated in the distribution pipe. In this way, the emission intensity can be analyzed in order to determine the pressure within the distribution pipe and to conclude on the coating rate.

In typical embodiments, the measurement device includes one or more, e.g., two, detectors and one or more, e.g., two, light sources. Generally, the term "light" within the present application refers to all kinds of electromagnetic radiation. In typical embodiments, the light emitted has a wavelength of greater than 1000 nm. Visible light between 400 nm and 700 nm is also often used, and also infrared radiation with wavelengths from 0,7 µm to 20 µm, more typically from 2 µm to 16 µm is frequently applied. The latter frequencies cover the typical vibrational spectra of organic materials, which may be conveniently used for rate measurement during application of organic materials. The at least one light source may be a laser, a white light lamp, or the like. In a typical embodiment, a laser with tunable wavelength is applied. So called quantum casacade lasers provide a wide tunable wavelength range of infrared radiation and may thus be used as a light source for infrared light according to embodiments.

The at least one detector may be a photodiode, a pin-diode, spectrometer, photo multiplier or the like. The detector may be connected to a multiplier. It is also possible to provide a spectrometer in order to analyze an electromagnetic spectrum.

Depending on the measuring method and/or measured characteristic property and/or vapor used, it is within the scope of this invention to apply infra red light or UV light or electromagnetic waves with even higher or lower frequencies.

In typical embodiments, the evaporator according to the present invention further includes an analyzer that is linked to the measurement device, e.g. by a data connection to the detector or its multiplier. It is possible that the analyzer is also linked to the light source in order to compare illumination and absorption and/or photoluminescence emission data. The analyzer typically determines the coating rate based on the information supplied by the measurement device. Further, typically, the analyzer has access to a memory. Data on typical absorption rates and/or photoluminescence activities of the organic vapor may be stored on the memory. For instance, the analyzer can be a personal computer, and the memory can be the hard drive of the personal computer or the like. The analyzer may have an input unit, such as a keyboard or a mouse to allow the operator to have influence on the actions of the analyzer and the units connected to the analyzer such as a controllable seat valve. Further, the analyzer may have an output unit, such as a screen or a plotter, for showing the operator information such as values received from the detector and/or calculation results calculated from these values. The data values measured and the data values stored in the memory may be jointly processed, e.g. compared, in order to determine the actual coating rate.

Typically, the distribution pipe is made of quartz glass. This allows the measurement of the absorption inside the distribution pipe of the evaporator within a large range of wavelengths and the measurement can be carried out with many different materials. Alternatively, the distribution pipe may be made of stainless steel or a ceramic material, in which case the pipe needs to be equipped with appropriate windows, which preferably includes quartz due to its wider transmission spectrum compared to other glass types.

Generally, the distribution pipe of the present invention can be a hollow body having at least one first outlet for applying vapor to a substrate, wherein the first outlet is preferably a nozzle, typically a plurality of nozzles. The distribution pipe is typically connected with a feeding unit, such as a crucible, for feeding the distribution pipe with vapor. The feeding unit is typically connected to the interior of the distribution pipe via an inlet, whereby the feeding unit may be an integral part of the distribution pipe. Typically, the distribution pipe includes between 15 and 100, more typically between 20 and 30 nozzle outlets. The diameter of the nozzle outlets is typically between 0,1 mm and 5 mm, more particular between 1 mm and 2 mm. The distribution pipe can be shaped as a tube or the like. In other embodiments, the distribution pipe is a shower head. Typically, the pipe is heated during the application process in order to avoid condensation of the vapour in the pipe. To this end, electrical heating elements may be arranged at the outer surface of the pipe.

If the numbers of nozzles and their respective area of openings are small in comparison to the total size/volume of the distribution pipe/tube, then the pipe is considered to be closed. The pressure within the tube is more stable and results in better coating processes and pressure measurements. Typically, the combined area of the first outlet, respectively the nozzles, and other outlets (described below) is lower than 10 % of the inner area of the pipe, more typically smaller than 5 %.

The distribution pipe typically includes two sections. The evaporation section includes the first outlet, typically a plurality of nozzles, for applying vapor to a substrate. This section defines a first fluidal path for the vapor, namely to go from the inlet to the first outlet, and subsequently to be supplied to a substrate to be coated. Secondly, the distribution pipe includes a measurement section including a second outlet. The second outlet is intended for displacing vapor from the measurement section, wherein the vapor is typically displaced out of the coating installation in which the evaporation system is employed. Thus, the measurement section defines a second fluidal path for the vapor to go from the inlet to the second outlet. Typically, the second outlet is adapted such that the vapor from the measurement section is not applied to the substrate. Typically, it is either guided to the opening of a vacuum pump in the coating installation, or might also be collected in the installation for subsequent disposal. I.e., the vapor from the measurement section may be applied to a surface other than the substrate inside the coating installation for later disposal. In embodiments, the displacement may be achieved by guiding the vapor from the measurement section by a tube or the like to the respective collection surface or area of the coating installation, or by guiding it to the vicinity of an opening leading to a vacuum pump.

By dividing the distribution pipe in an evaporation section and a measurement section as described, it is possible to also separate the part of the vapor used in the measurement section from the vapor used for coating a substrate. This is because the vapor may be altered in its properties during the measurement process, namely by applying light. Any optical measurement process described herein necessarily influences the material which is radiated in the process, at least by temporarily enhancing the internal energy level of the atoms or molecules involved through absorption. The molecules may even deteriorate due to the applied radiation, which is particularly relevant if the applied light is tuned to a frequency where the molecules to be measured have absorption maxima, and if the light source has a high energy density, such as a laser. The nature and details of these phenomena are well known to those skilled in the art. Basically, the undesirable deterioration of the vapor molecules is strongly dependent on the chemical composition of the vapor, its absorption spectrum, and the nature and intensity of the applied radiation.

As an example, organic substances used in the production of OLEDs have characteristic absorption spectra in the infrared region. For instance, NPB, which is frequently applied in OLEDs, has a number of characteristic absorption peaks in the range from about 5 µm to 16 µm. For instance, in conjunction with infrared laser light from a tunable quantum cascade laser as a light source, this may be conveniently used in the measurement process according to embodiments. However, some molecules also have a significant tendency to deteriorate above certain radiation levels in the frequency range used for measurement. For instance, the properties of OLED displays may be significantly and undesirably altered when part of the applied organic material was subject to an optical measurement process and was subsequently used in the coating process.

Hence, by disposing at least a part of the vapor used in the optical measurement process, the quality of the products of the respective coating process may be assured, respectively a negative effect of partial deterioration, or other quality degrading effects, of the vapor due to the application of light is avoided. For achieving the separation of the vapor used for the measurement from that used for coating a substrate, in a method according to embodiments, the vapor coming from the inlet is divided into one part going into the measurement section, and one part going into the evaporation section of the distribution pipe. Subsequently, the vapor from the measurement section is guided, respectively directed or disposed such that it does not reach the surface of a substrate to be coated. Preferably, the displaced vapor is guided out of the coating installation, or collected at a location where it does not contribute to the coating.

Typically, a gauging step is performed in the method according to embodiments, prior to the application of vapor to the substrate. Generally, the correlation of the deposition rate and the absorption and/or photoluminescence activity is gauged at the beginning of the coating. A gauging step can be repeated during evaporation of substrates, e.g., in specific time intervals or constantly. It is also possible that gauging is undertaken during substrate coating. For instance, the coating thickness of the coated substrates can be examined directly after the coating step and be correlated to the characteristic property measured at the time of coating the respective substrate.

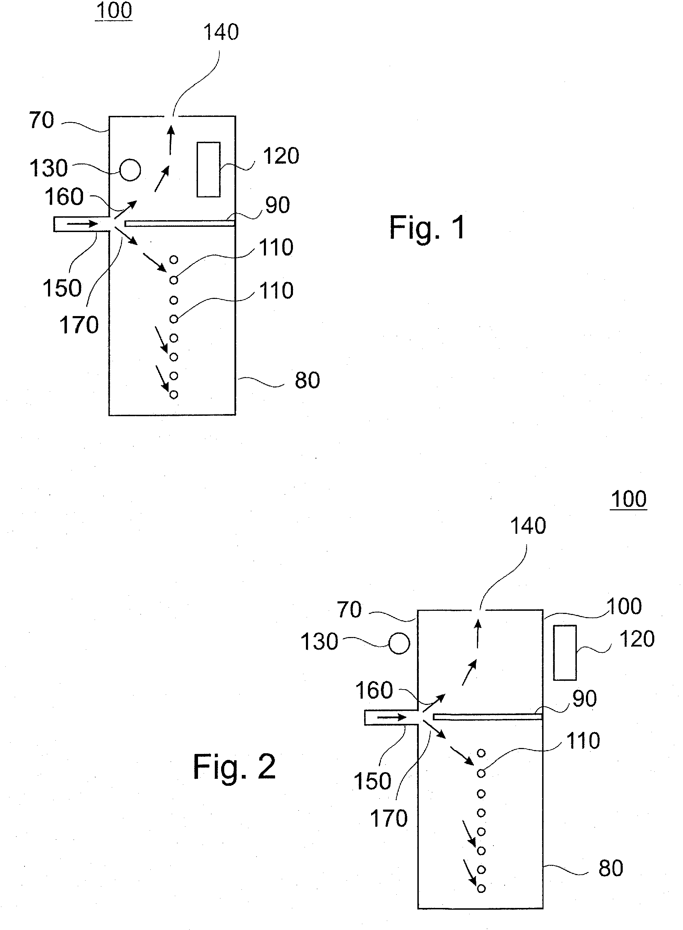

Fig. 1 shows a first embodiment of the evaporator. The distribution pipe 100 of the evaporator includes an outlet, typically in form of a multitude of nozzle outlets, which together form a first outlet 110. The diameter of a typical distribution pipe according to the present invention is between 1 cm and 10 cm, more typically between 4 cm and 6 cm. When evaporating a substrate with organic material, the pressure within the distribution pipe, which is larger than the pressure outside, causes the organic vapor to stream out of the distribution pipe towards a substrate (not shown). In the view shown in Fig. 1, the substrate would be positioned above the paper plane. In typical methods for coating a substrate, the organic vapor is applied to the substrate in a vacuum atmosphere. The term vacuum shall refer to a pressure of 10⁻² mbar and below. Typically, the nozzle outlets are shaped and arranged such that the flow of vapor of one nozzle outlet overlaps with the flow of vapor of a next neighbour nozzle outlet on the substrate surface.

In order to control the coating rate, the organic evaporator according to the embodiment shown in Fig. 1 includes a measurement device for acquiring measurement data about a characteristic property of the organic vapor within the distribution pipe 100. The measurement device is typically adapted to acquire measurement data about a characteristic property of the organic vapor within the distribution pipe. The measurement device includes light source 130 which can be, for instance, a laser or a traditional white or coloured light source having a specific spectral distribution. It is also possible that the light source includes a light emitting unit having a wide distribution and a filter in front to allow only a specific range of wavelengths to pass. It is also possible that the light source referred to as number 130 represents the end of a fibre optic cable. In other words, in embodiments of the present invention, there may be a fibre optics arranged for transmitting the light to the distribution pipe. The detectors could also be connected via fibre optics. This would enable the use of certain detectors which otherwise would not properly function in particular environments.

The measurement device further includes the detector 120. The detector 120 measures the radiation arriving from the light source 130. Typical examples for the detector are pin-diodes, spectrometer, photo diodes, photo multipliers etc. The detectors could also be connected via fibre optics. This would enable the use of certain detectors which otherwise would not properly function in hot environments. Also, it is possible to arrange a filter in front of the detector to let only the photons having a wavelength of interest pass through. This wavelength could be, for instance, the characteristic photoluminescence emission wavelength of the specific organic material in the distribution pipe.

According to one embodiment of the present invention, the absorption rate within the distribution pipe is measured as characteristic property of the organic vapor. According to another embodiment of the present invention, the luminescence activity of the organic vapor within the distribution pipe is measured as the characteristic property. The detector 120 in Fig. 1 allows for the measurement of the absorption rate within the distribution pipe. When photoluminescence is measured, it is of advantage, but not necessary, to provide a hole (or numb spot) at the point of direct incidence of the light of the light source on the detector to strengthen the signal quality. It is also possible to arrange the detector in an area outside the direct light passage.

When measuring the absorption rate, it is possible to deduce the pressure of the material in the distribution pipe from the absorption of certain wavelengths within the distribution pipe. As explained before, the coating rate can be deduced from the absorption rate. This information can, in turn, be used for controlling the coating rate.

The distribution pipe of Fig. 1 is divided into two sections by a separator 90. Vapor streaming into the pipe 100 (direction of flow represented by arrows), typically from a heated crucible (not shown) via inlet 150, is divided by separator 90. One portion 170 of the incoming vapor is guided into the evaporation section 80, from where it leaves pipe 100 through first outlet 110, which typically includes a plurality of nozzles. Another portion 160 of the vapor is guided into measurement section 70, where a characteristic optical property of the vapor is measured by detector 120. After passing the measurement section, the vapor leaves distribution pipe 100 through second outlet 140. From there, it is typically guided out of a coating installation in which the pipe 100 is employed. The division of the vapor by separator 90 is typically designed such that a larger amount of vapor is guided into the evaporation section 80, typically about 70 to 99,5 percent,more typically 80 to 97 percent. Respectively, a much smaller amount is guided into the measurement section. This may be achieved by placing separator 90 such that the cross-section of the opening leading into the measurement section 70 is significantly smaller than the opening leading to evaporation section 80. Generally, the arrows used herein only symbolize the flow direction of vapour. The number or density of arrows per area is neither related to a vapour density nor indicative for any quantitative parameter.

Fig. 2 shows another embodiment, wherein light sensitive detector 120 and light source 130 are both positioned outside distribution pipe 100 on opposite sides of the pipe. As the distribution pipe is typically heated to a temperature of about 100° C to 500° C, this arrangement allows for the application of sensors and light sources which are sensitive to such temperatures and would not be applicable inside the pipe.

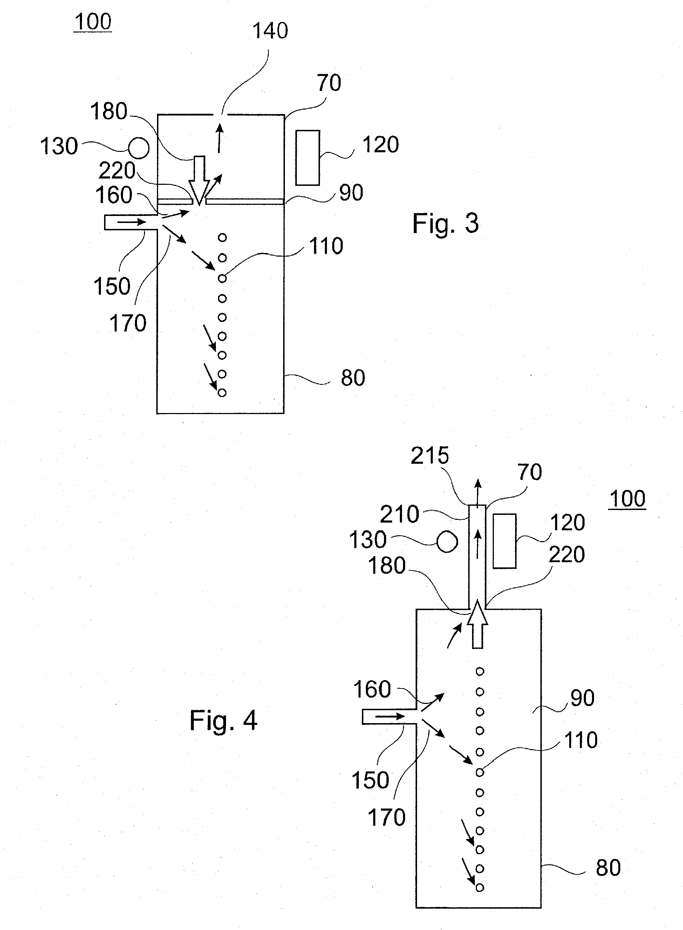

Fig. 3 shows a further embodiment, in which a seat valve 180 opens and closes, respectively regulates the connection between measurement section 70 and evaporation section 80. In Fig. 3, the seat valve opens and closes opening 220 in separator 90 and thus regulates the throughput of vapour into the measurement section 70. If the valve is, e.g., opened in intervals with a defined hub, it may be controlled how much vapor from the evaporation section 80 streams into the measurement section 70. Alternatively or additionally, the hub of the seat valve may be controlled and varied, so as to control the amount of vapor streaming into the measurement section. These actions are typically controlled in conjunction with analysis devices (not shown) connected to light sensitive sensor 120, so as to be able to synchronize respective measurement data with information on when vapor is guided into the measurement section 70. By regulating the amount of vapor streaming into the measurement section 70, it is possible to more precisely control the amount of vapor used for the measurement process, than in the previous embodiments.

The embodiment shown in Fig. 4 shows another option of dividing a part of the vapor from the evaporation section 80 to measurement section 70. Therein, a tube or tube section 210 is connected to the distribution pipe 100 at opening 220 in the distribution pipe. Preferably, but not necessarily, the connection between pipe 100 and the tube 210 is regulated by a valve 180. A portion of the vapor flows through opening 220 into tube 210. This tube serves as the measurement section 70, alternatively the tube may be connected to a further cavity (not shown) forming the measurement section. Detector 120 and light source 130 are located in the vicinity of tube 210. Typically, tube 210 includes quartz in order to allow transmission of the radiation through measurement section 70. The sensor and light source may also be provided in a further cavity (not shown) connected via tube 210 to the evaporation section 80. The vapor leaves the measurement section 70, which includes tube 210, via the second outlet 215. In other embodiments, cavities with different shapes than the tube shape in Fig. 4 are employed.

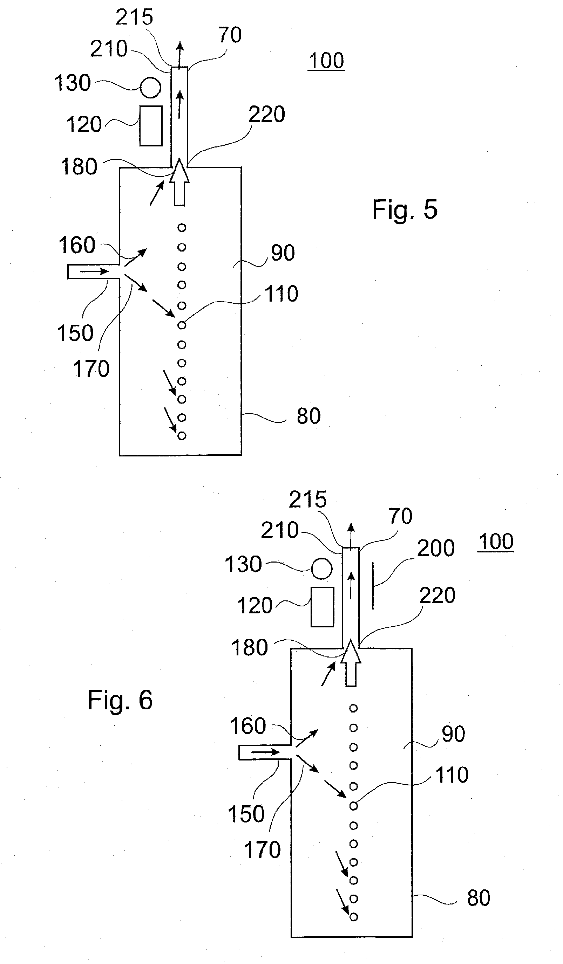

Fig. 5 shows a distribution pipe similar to the embodiment shown in Fig. 4, but having a different arrangement of light source 130 and detector 120. As they are both positioned on one side of the tube 210, which includes measurement section 70, this embodiment is suitable for measuring the photoluminescent activity of the vapour as a characteristic property. For this purpose, light is sent into the distribution pipe thereby exciting the vapor. Typically, the light is of a certain wavelength. The excited molecules fall back to the ground state, thereby emitting radiation. The characteristic emission wavelength is detected by detector 120 such as an emission spectrometer. As the intensity of the emission depends directly on the pressure of the material to be evaporated, a correlation between pressure and emission intensity can be established and be used to control the coating rates. The vapor leaves measurement section 70, respectively tube 210, via second outlet 215 after the measurement process.

Fig. 6 shows a further embodiment with a similar arrangement of detector 120 and light source 130 as in Fig. 5, but with an additional mirror located on a side of tube 210 opposite to the detector and light source. As the mirror reflects the light of the light source back to the detector, this arrangement is suitable for measuring the absorption rate of the vapour. As the light passes the measurement section 70, and hence the vapor therein twice, a higher detection sensitivity may be acquired than by having the light pass the vapour only once before being detected.

The skilled person will derive from the embodiments described that there are a variety of arrangements of the light source, detector and mirror with respect to a measurement section. All have certain advantages, depending on the individual case, and depending if an absorption rate or a photoluminescent activity shall be measured. Also, similar arrangements not described herein are regarded to fall into the scope of the present application.

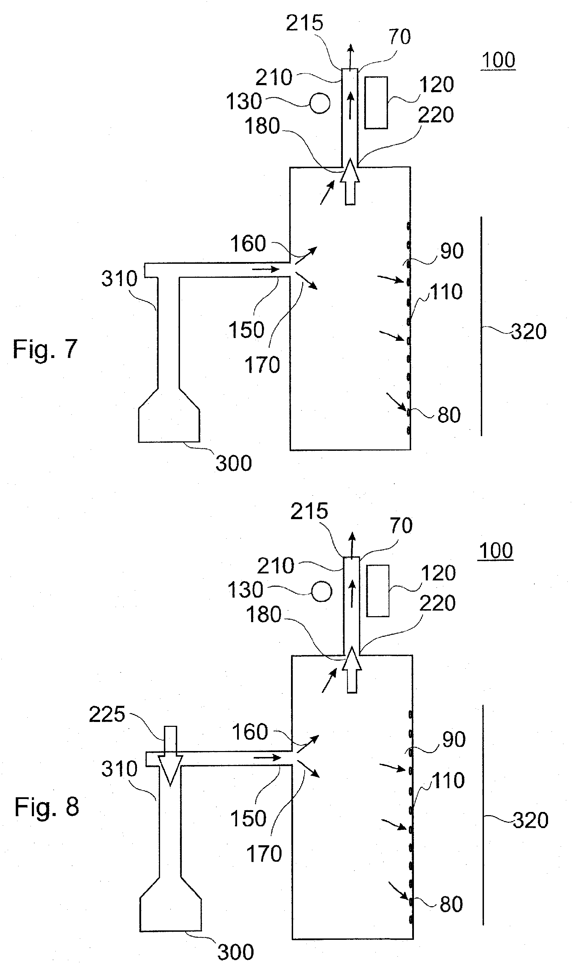

The embodiment shown in Fig. 7 is similar to the embodiment shown in Fig. 4, additionally showing a heatable crucible 300 connected via a supply tube 310 to the inlet 150 of the evaporation section 80. The nozzles of outlet 110 are facing to the right, where the substrate 320 to be coated is located. In Fig. 4, the crucible is not visible, because it is kept from the eye by pipe 100. Further, in Fig. 7, the detector 120 is positioned at the same side of the evaporator as the light source 130. The crucible 300 can be filled with the coating material in solid or liquid form. The crucible is then heated to a temperature at which the material partly changes its state of aggregation into vapor.

Typically, the distribution pipe 100 has a closed geometry. That is, the nozzles respectively holes of outlet 110, together with the outlet of the measurement section, are the only openings for the vapor to exit the evaporator. Due to the higher pressure within the organic evaporator in comparison to the pressure in the surrounding atmosphere, the vapor streams out of the distribution pipe onto the substrate 320. Typically, the pressure within the closed geometry of the evaporation section and, generally, also in the measurement section, corresponds to the vapor pressure of the organic material. This pressure is typically in the 10⁻² mbar range, for instance between 2-4 x 10⁻² mbar. Thereto in contrast, the pressure outside the organic evaporator is typically between 10⁻⁴ mbar and 10⁻⁷ mbar.

It is further possible to arrange a seat valve somewhere between the crucible and the distribution pipe. This is exemplarily shown in the embodiment of Fig. 8, where the valve 225 is positioned between the vertical part of the supply tube 310 and its horizontal part. In the embodiment shown, the crucible 300 is connected to the distribution pipe via the seat valve. The seat valve 225 is manually or automatically controllable. For instance, the seat valve may be completely closed if the deposition of material is to be temporarily stopped. In general, it can be controlled in order to control the material density within the evaporator. That is, the seat valve can be used for controlling the coating rate of the evaporating system. Typically, the seat valve can be linked to and be controlled by an analyzer. It is also possible that there are more than one seat valves installed in the organic evaporator according to the present invention. For instance, one seat valve could be controlled manually, and another seat valve could be controlled by the analyzer.

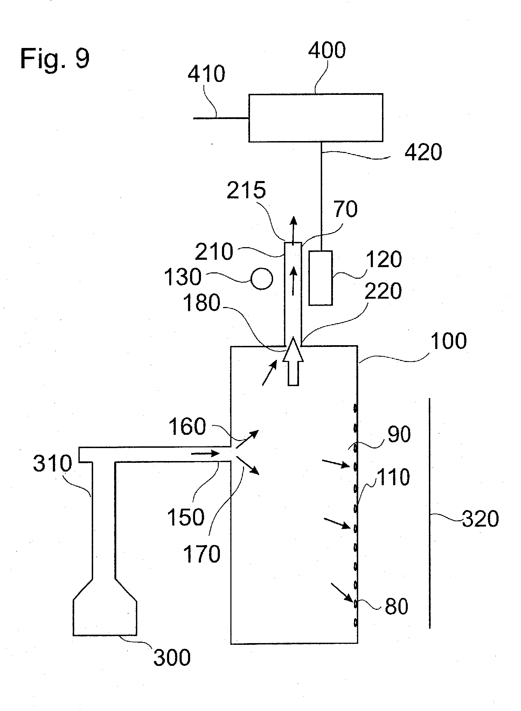

Fig. 9 shows a further embodiment. Further to the elements already shown with respect to Fig. 7 and 8, the embodiment of Fig. 9 includes an analyzer 400. The analyzer is connected to the detector 120 via the connection 420. Further, the analyzer is connected to means for controlling the coating rate of the evaporation system, via the connection 410. For instance, such means can be a seat valve 225 as described with respect to the embodiment of Fig. 8, or a heat control that controls the temperature of the crucible filled with organic material, or the like. The analyzer is typically also connected (not shown) to the seat valve 180 in order to regulate the amount of vapor streaming into tube 210, respectively the measurement section 70. When the evaporator is operated, the coating rate is measured by the measurement device including the light source 130 and the detector 120. The information detected by the detector 120 is fed to the analyzer 400 for analyzing the information. The analyzer determines the actual coating rate at which the substrate is coated by evaluating this information. If the coating rate is too high, the means for controlling the coating rate are instructed to reduce the coating rate. As already set forth, this could be done by reducing the seat valve opening as in Fig. 8 (not shown in Fig. 9). Other means for reducing the actual coating rate on the substrate are also within the scope of the present invention. For instance, depending on the process steps before and after the organic coating of the substrate, also the speed of the substrate 320 passing the nozzle outlets 110 could be increased or decreased depending on whether the actual coating rate is too high or too small.

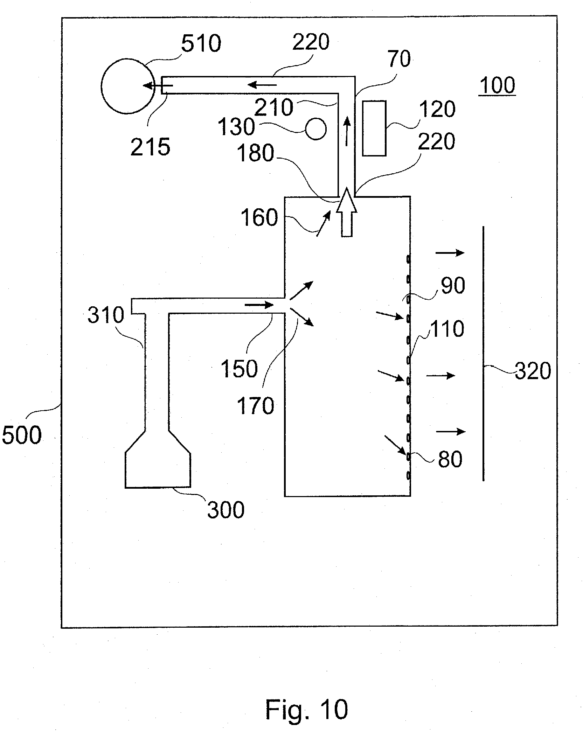

Fig. 10 is a cross sectional side view on an embodiment of a coating installation according to the present invention. Fig. 10 shows the evaporation system according to the embodiment of Fig. 7 arranged within a vacuum chamber 500, that is typically evacuated by one or more vacuum pumps 510 during operation. As was described before, the vapour from measurement section 70 is guided via tube 220 to an inlet of the vacuum pump 510. Accordingly, the vapour that was used in the measurement process is displaced from the vacuum chamber and not used for the coating of substrate 320. This vapour might also be guided via a tube to a surface different from the substrate 320 within the chamber 500, where it is condensed and thus collected. That surface may be cleaned or disposed, after the coating process or after some time of operation.

Typically, the coating installation according to the present invention has further process chambers which are positioned before and/or after the evaporation system. The organic evaporation system of the present invention is typically used as a vertical linear organic evaporator. Typically, the substrates are processed in-line. That is, the organic material is horizontally evaporated onto a substrate that is vertically oriented. The substrate is typically continuously transported by an assembly line with different process chambers being positioned in a row. In typical embodiments, the time interval needed for coating is in the range of between 10 seconds and 4 minutes, more typically between 30 sec and 90 sec for one substrate. The coating frequency refers to the number of substrates being coated in the time specified.

The coating installation of the present invention may include several evaporators according to embodiments of the present invention. The several process chambers may have different levels of vacuum. Typically, the substrate to be coated undergoes one or more cleaning process steps before entering the chamber for organic evaporating. It is further typical that the substrate is coated with an inorganic layer after the deposition of one or more organic layers. This is due to the fact that organic materials are sensitive to oxygen. Therefore, a cap layer will protect the organic material layer in many embodiments.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. Evaporation system for applying vapor to a substrate (320) in a vacuum chamber (500) at a coating rate, the system comprising a distribution pipe (100) comprising:
- an inlet (150) for receiving the vapor;
- an evaporation section (80) having a first outlet (110) for applying the vapor to the substrate (320), the evaporation section defining a first fluidal path for the vapor to go from the inlet (150) to the first outlet (110),
- a measurement section (70) having a second outlet (140, 215) for displacing the vapor from the measurement section (70), the measurement section defining a second fluidal path for the vapor to go from the inlet (150) to the second outlet (140, 215); and
- a light sensitive detector (120) for measuring at least one characteristic property of the vapor in the measurement section (70).

2. Evaporation system according to claim 1, wherein the first outlet (110) comprises at least one nozzle.

3. Evaporation system according to claims 1 or 2, further comprising a valve (180) between the measurement section (70) and the evaporation section (80).

4. Evaporation system according to any preceding claim, wherein the second outlet (140, 215) is adapted for displacing vapor to an outside of the vacuum chamber (500).

5. Evaporation system according to any preceding claim, further comprising a light source (130), wherein the light source comprises a laser and a glass fibre.

6. Evaporation system according to any preceding claim, wherein the vapor comprises an organic vapor.

7. Evaporation system according to any preceding claim, further comprising
- an analyzer (400) linked to the light sensitive detector (120) for analyzing measurement data in order to determine a coating rate.

8. The evaporation system according to any of the preceding claims, wherein the at least one characteristic property of the vapor comprises the absorption rate of the organic vapor and/or or a photoluminescent activity of the vapor.

9. Vacuum chamber (500) for coating substrates (320), with at least one evaporation system (100) according to any preceding claim.

10. Method for measuring the application rate of vapor to a substrate in a vacuum chamber (500), comprising:
- providing vapor in a distribution pipe (100);
- applying a first portion (170) of the vapor to the substrate (320);
- diverting a second portion (160) of the vapor to a measurement section (70);
- applying laser light to the vapor in the measurement section (70);
- measuring at least one characteristic property of the vapor.

11. Method according to claim 10, further comprising:
- exhausting at least a part of the vapor from the measurement section (70) to an outside of the vacuum chamber (500).

12. Method according to claims 10 or 11, wherein diverting a second portion of the vapor (160) to the measurement section (70) is carried out by opening and closing a valve (180).

13. Method according to claims 10 to 12, wherein the measured characteristic property of the vapor is an absorption rate and/or or a photoluminescent activity.

14. Method according to claims 10 to 13, wherein the laser is a quantum cascade laser, and wherein the laser light has a wavelength spectrum of from 1 µm to 20 µm.

15. Method according to any of claims 10 to 14, further comprising analyzing the measurement data of the characteristic property, and adapting the evaporation rate.
